# EUROPEAN PATENT SPECIFICATION

(11) **EP 2 388 608 B1**
(45) Date of publication and mention of the grant of the patent: **11.09.2013**
(21) Application number: 11165791.2
(22) Date of filing: 12.05.2011
(51) Int. Cl.: G01R 33/04

(54) **Fluxgate sensor circuit for measuring the gradient of a magnetic field**
Fluxgate-Sensor-Schaltung zur Gradientmessung des magnetischen Feldes
Circuit d'une sonde fluxgate pour le mesurage du gradient de champ magnétique

(30) Priority: 18.05.2010 CZ 20100384
(43) Date of publication of application: 23.11.2011
(73) Proprietor: Ceské Vysoké Ucení Technické V Praze, 166 27 Praha 6 (CZ)
(72) Inventor: Janosek, Michal, 40755 Dolni Podluzi (CZ); Ripka, Pavel, 25230 Revnice (CZ)
(74) Representative: Duskova, Hana

(56) References cited:
- GB-A- 2 319 621
- GB-A- 2 438 057
- US-A- 4 617 516
- POULADIAN-KARI R ET AL: "RAPID COMMUNICATION; A new multi-concentric coil arrangement for producing a near-linear gradient of axial magnetic field", MEASUREMENT SCIENCE AND TECHNOLOGY, IOP, BRISTOL, GB, vol. 1, no. 12, 1 December 1990 (1990-12-01), pages 1377-1379, XP020066151, ISSN: 0957-0233, DOI: 10.1088/0957-0233/1/12/023

## Description

### Background of the Invention

The invention deals with a fluxgate sensor designed for precise measurement of the first-order gradient of magnetic fields in feedback compensating mode, while allowing to simultaneously measure also the homogeneous component of these fields. With a single sensor, it is therefore possible to design a gradiometer as well as a magnetometer in compensating mode.

### Description of Prior Art

Fluxgate sensors are used for precise measurements of weak magnetic fields in various social spheres - in cosmic research, in medicine and safety applications, and also for instance as a sensor for navigation. From the whole group of magnetic sensors operating at non-cryogenic conditions fluxgate sensors still retain the best parameters, such as absolute accuracy, resolution, linearity and noise, however they are always limited by their minimum size, below which the parameters begin to degrade.

The fluxgate sensor principle is well known and can be found together with typical block-diagrams of a feedback-operated fluxgate magnetometer for example in P. Ripka (ed.), Magnetic Sensors and Magnetometers, Artech House Publishers, 2001, ISBN 1-58053-057-5. Fluxgate sensor function is based on alternated saturation of the ferromagnetic core by so-called excitation field and on detection of changes in the flux caused by external, it means measured, magnetic field. External magnetic field is therefore modulated in the alternating flux inside the ferromagnetic core. Fluxgate sensors exist in parallel or perpendicular configurations where the expression configuration means a relative direction between the excitation field and the measured field. Parallel-type fluxgate sensor in principle consists of the excitation coil wound around the ferromagnetic core and of the pick-up coil, which is wound on the same place, while the perpendicular-type fluxgate sensor uses alternating current flowing longitudinally through the ferromagnetic core, or its non-magnetic sub-core respectively, forming the excitation field perpendicular to the measured field, and it has the same pick-up coil wound around the core. One direct example is the wide-bandwidth, rod-type fluxgate by P. Robertson, GB 2319621, 1998 and its modification in GB 2438057, 2007. It is a parallel-type fluxgate sensor, where the pickup and excitation coil can be combined with the help of subtracting the first-harmonic excitation signal by a differential amplifier. The signal processing electronics used a certain type of even-harmonic demodulator, or a time-domain comparator was used. In order to enhance the fluxgate sensors linear range and to improve some parameters, such as linearity, temperature dependence of sensitivity or off-set, a compensating feedback is commonly used.

By means of separate compensating coil or combined pick-up/compensating coil, this compensating feedback creates the magnetic field acting against the measured field, i.e. the fluxgate sensor then works as a zero detector in a feedback loop. Normally, the feedback loop circuitry consists of the previously mentioned demodulator; its output is connected to an integrator which acts as an I-type regulator ensuring zero regulating error. The integrator output is buffered by a voltage-to-current converter (active or passive with a resistor) which ensures minimal loading of the feedback coil by the regulator output. In Robertson, GB 2319621, a P-regulator was used as the required bandwidth was high.

Regular gradiometer with a fluxgate sensor uses two separate sensor heads, each head with a single sensor, as used in GB 2438057, 2007, Figure 2, or with an orthogonal triplet of such sensors. In this case, individual fluxgate sensors typically work in a compensating feedback. So-called gradiometric base, which is the distance between individual sensor heads, affects resolution and noise when measuring the magnetic gradient and simultaneously it defines the rate of approximation of measured value to the magnetic gradient, which is a local quantity expressed as a derivation of the function of magnetic field flux curve at given point. In general, the magnetic field gradient is the second-order tensor, with components ∂Bi/∂j, where i and j are components of the system of coordinates. In case of a regular gradiometer with separate heads formed by orthogonal triplets of sensors, all independent components of the magnetic field gradient are measured.

Such gradiometers feature the following disadvantages. Gradiometric base is limited by certain minimum distance, which is in order of tens of centimeters, and is determined in particular by mutual interaction of sensors operating in feedback compensating mode, when the compensating field of one sensor affects the other sensor. Partially, this can be solved by using the compensating current of one sensor also for the second sensor; gradient reading then is obtained from uncompensated signal of the second sensor. Magnetic gradient approximation in such cases is rather rough. If the gradiometer is used for suppressing the interfering fields during measurements of point sources (magnetic nano-particles in medicine), the length of the base does not allow to efficiently suppress close sources of interference. Gradiometric base should then be minimum as great as the distance from the measured source, as was described in Merayo, Petersen, Nielsen, Primdahl, Brauer, A portable single axis magnetic gradiometer, Sensors and Actuators A: Physical, Volume 93, Issue 3, October 2001, pp. 185-196. In addition, the angular deflection between the sensor heads affects the error in measurements of the magnetic gradient, or spurious sensitivity to homogeneous fields respectively, and therefore it requires rather stable fixing of sensors, especially for short gradiometric bases.

Another type of a gradiometer with fluxgate sensor is a so-called "single-core fluxgate gradiometer", i.e. gradiometer with a single fluxgate sensor, or with a single core respectively, which allows to shorten the gradiometric base under 10 cm and to maintain low noise level. Such gradiometer measures the magnetic field gradient ∂Bj/∂j, where j is one of the axes of the system of coordinates. The principle here is exploitation of two or more pick-up coils surrounding the ferromagnetic core of the sensor with the spacing, which defines the gradiometric base, and using either separate blocks of electronics or connection of these coils in anti-series and a single electronics in such a way, which will result in suppressed response to homogeneous fields and in obtaining the response to the gradient-type fields. Gradiometers of this type were implemented using the fluxgate sensor with rod- or oval-shaped core. These gradiometers operated in uncompensated mode and measured simultaneously the gradient and the homogeneous component of the field. However, they feature the following disadvantages. Up-to-date types feature high spurious sensitivity to homogeneous fields, i.e. with perfectly homogeneous field the gradiometer response is not zero. Due to open loop both for the homogeneous and the gradient fields, the parameters are unstable, sensitivity and linearity is low, which results in a limited usability of such gradiometers.

One possible embodiment of a "single-core" gradiometer is described in the patent US 5130654, Mermelstein, Marc D., Magnetolelastic amorphous metal ribbon gradiometer, where the rod core is excited piezoelectrically and the gradient is determined by two separate blocks of electronics connected to individual coils.

Another possible solution is described in Pavel Ripka, Petr Navrátil, Fluxgate sensor for magnetopneumometry, Sensors and Actuators A: Physical, Volume 60, Issues 1-3, Proceedings of Eurosensors X, May 1997, pp. 76-79. The principle of this solution is using the "race-track" oval core and several coils connected in anti-series with a single block of electronics. Disadvantages of both the above-mentioned solutions were the spurious sensitivity to homogeneous fields and high instability of parameters given by functioning in the open loop.

Appropriate compensation of the magnetic field gradient, necessary for closing the gradiometer's compensating loop, has not been proposed so far. The most significant issue is the need to create a gradient field with zero homogeneous component such that will allow to achieve the compensating mode. Achieving properly functioning feedback is yet another issue. Theoretically, the design published in Pouladian-Kari: "A new multi-concentric coil arrangement for producing a near-linear gradient of axial magnetic field" in magazine Measurement Science and Technology 1, 1990, pp. 557-559, could serve as a basis for the coil design. Disadvantages of this arrangement, however, include great dimensions and complex structure where the coils are gradually layered one over another and each single coil has different diameter, length and also the number of coil turns. A more practical solution is creating a coil that its winding diameter is the same throughout the whole length and the number of coil turns per length unit decreases linearly from one end towards its center where the winding direction turns into the opposite. From this center towards the other end of the coil the number of coil turns would increase analogically. This was accomplished by Schenck, 1986, US 4617516, by varying the turns density in the NMR gradient coil. He also proposed additional winding turns for compensating of variations in the linearity of the magnetic field. However also in this case the manufacturing is not simple: the continuously varying winding density requires precise CNC turning with varying movement of the sample, or other advanced manufacturing technique.

### Summary of the Invention

Disadvantages mentioned above are eliminated by the fluxgate sensor circuit for measuring the gradient of a magnetic field according to the presented solution. Fluxgate sensor consists of, as in case of already known solutions, the ferromagnetic core of arbitrary shape with either parallel or perpendicular direction of the excitation field. Ferromagnetic core is either equipped with the excitation winding connected to the excitation block or the ferromagnetic core is connected to the excitation block directly. Another part of the circuit is the gradient coil wound around the ferromagnetic core, which is connected with the first signal processing block by means of the controlled first phase shifter interconnected with the excitation block. Principle of the new solution is that the gradient coil is located concentrically and coaxially with respect to the ferromagnetic core and it is created as a gradient compensating/pick-up coil. Its winding diameter is the same throughout the whole length and the number of coil turns per length unit decreases linearly from one end of the fluxgate sensor towards its center where the winding direction turns into the opposite. From this center towards the other end of the fluxgate sensor the number of coil turns increases analogically. Gradient compensating/pick-up coil is simultaneously connected with the output of the first U/I converter, which is connected with the output of the first inverting integrator. Input of the first inverting integrator is connected with the output of the signal from the first signal processing block.

In one possible embodiment the winding of the gradient compensating/pick-up coil is discretized into a setup of narrow, homogeneously wound sections connected in series having identical diameter and width. These sections are located with identical spacing around the ferromagnetic core. Always the two sections located mutually coaxially against the center of the fluxgate sensor have the same number of coil turns, which from one end of the fluxgate sensor decreases linearly and, towards the other end, it increases analogically.

In both described embodiments a homogeneous compensating/pick-up coil is wound coaxially and concentrically with respect to the gradient compensating/pick-up coil. This homogeneous compensating/ coil is connected with the second signal processing block, while the control input of this second signal processing block is connected with the output of the second phase shifter. The second phase shifter is interconnected with the excitation block. This homogeneous compensating/pick-up coil is simultaneously connected with the output of the second U/I converter connected to the output of the second inverting integrator. Input of the second integrator is connected with the output of the signal from the second signal processing block.

Advantage of the new solution is the fact that in the compensating mode the gradient of magnetic field type ∂Bⱼ/∂j is measured, while the homogeneous component of this field can be measured simultaneously. Using the compensating mode at the gradient compensating/pick-up coil results in significantly higher sensitivity to the magnetic gradient, higher linearity of the sensor and parameters stability. Simultaneous compensating mode of measuring the homogeneous field causes significant reduction of spurious sensitivity of gradient response to this homogeneous field, suppression is 500 times better than the one achieved in solution described in material Pavel Ripka, Petr Navrátil, Fluxgate sensor for magnetopneumometry, Sensors and Actuators A: Physical, Volume 60, Issues 1-3, Proceedings of Eurosensors X, May 1997, pp. 76-79. The reason is stable zero homogeneous, it means average, component of the field in the area of the ferromagnetic core where possible core inhomogeneities are no longer excited by the external field and therefore they do not contribute to false readings of the gradient pick-up coil. Gradient compensating/pick-up coil is easy to manufacture and it can be externally attached to any already existing fluxgate sensor, where it will add the option of compensating measurement of the field gradient component.

### Overview of Figures in Drawings

Examples of embodiments of the fluxgate sensor circuit for measuring the gradient of a magnetic field according to the presented solution are schematically shown in the attached drawings. Fig. 1 shows the complete block diagram of the circuit with gradient compensating/pick-up coil with continuous winding, fig. 2 shows the same circuit with gradient compensating/pick-up coil with winding discretized into a setup of homogeneously wound sections connected in series. Figs. 3 to 6 show examples of a gradient compensating/pick-up coil with discretized winding on various types of cores. Fig. 7 shows a diagram explaining the circuit function.

### Detailed Description of the Preferred Embodiments

Fluxgate sensor circuit for measuring the gradient of a magnetic field consists of the fluxgate sensor with specially wound gradient coil designed to compensate the magnetic field gradient.

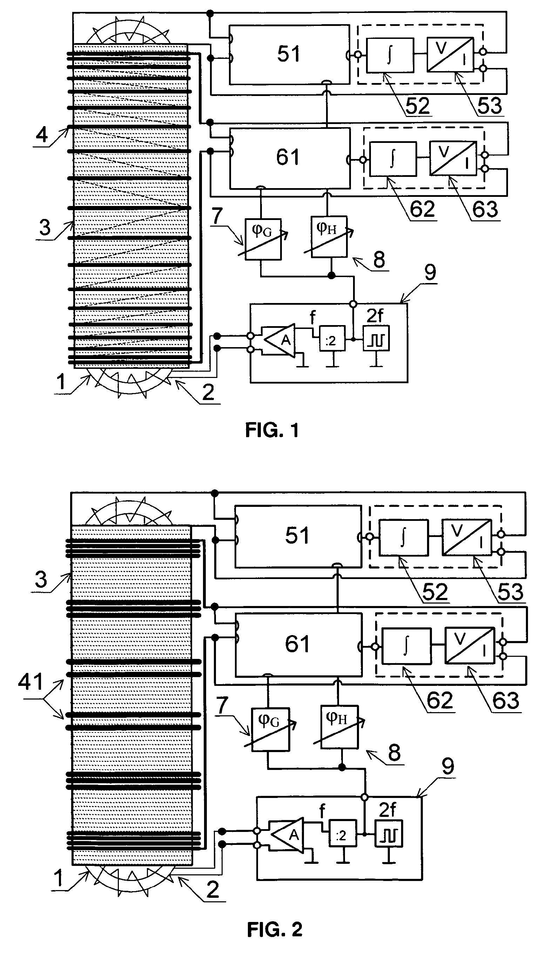

One possible embodiment of the fluxgate sensor circuit for measuring the magnetic field gradient is shown in fig. 1. Fluxgate sensor consists of the ferromagnetic core 1 of arbitrary shape with either parallel or perpendicular direction of the excitation field. Ferromagnetic core 1 can be either equipped with the excitation winding 2 connected to the excitation block 9, or the ferromagnetic core 1 is connected to the excitation block 9 directly in case the excitation field has perpendicular direction. Around the ferromagnetic core 1 is wound the gradient coil, which is connected with the first signal processing block 61 by controlled first phase shifter 7 interconnected with the excitation block 9. The first signal processing block 61 can be created in various ways. For example, it can be formed by an amplifier and phase sensitive rectifier connected to the output of the first phase shifter 7. Gradient coil is located concentrically and coaxially with respect to the ferromagnetic core 1 and it is created as a gradient compensating/pick-up coil 4, where its winding has the same diameter throughout the whole length and the number of coil turns per length unit decreases linearly from one end of the fluxgate sensor towards its center. Here the winding direction turns and from this center towards the other end of the fluxgate sensor the number of coil turns per length unit increases analogically. Gradient compensating/pick-up coil 4 is simultaneously connected with the output of the first U/I converter 63, which is connected to the output of the first inverting integrator 62, the input of which is connected with the output of the signal from the first signal processing block 61.

Gradient compensating/pick-up coil 4 can also be created in such a way that its winding is discretized into a setup of narrow, homogeneously wound sections 41 connected in series, see fig. 2, with identical diameter and width and located with identical spacing around the ferromagnetic core 1 in such a way that the number of coil turns of these partial sections 41 in the setup decreases linearly from the end of the sensor towards its center where the winding direction turns and further the number of coil turns of individual sections 41 increases analogically towards the other end of the sensor. Always the two sections 41 located mutually coaxially against the center of the fluxgate sensor with opposite winding direction have the same number of coil turns.

Another possible embodiment features a homogeneous compensating/pick-up coil 3, wound coaxially and concentrically with respect to the gradient compensating/pick-up coil 4, and this homogeneous compensating/pick-up coil 3 is connected with the second signal processing block 51. This second signal processing block 51 may again be designed in various ways, analogically with the first signal processing block 61 for instance it may be formed by an amplifier and phase sensitive rectifier. The second signal processing block 51 is connected to the second phase shifter 8 interconnected with the excitation block 9. This homogeneous compensating/pick-up coil 3 is simultaneously connected with the output of the second U/I converter 53 connected to the output of the second inverting integrator 52, the input of which is connected with the output of the signal from the second signal processing block 51. Homogeneous compensating/pick-up coil 3 can be wound directly on the ferromagnetic core 1 under the gradient compensating/pick-up coil 4 or on top of this gradient compensating/pick-up coil 4.

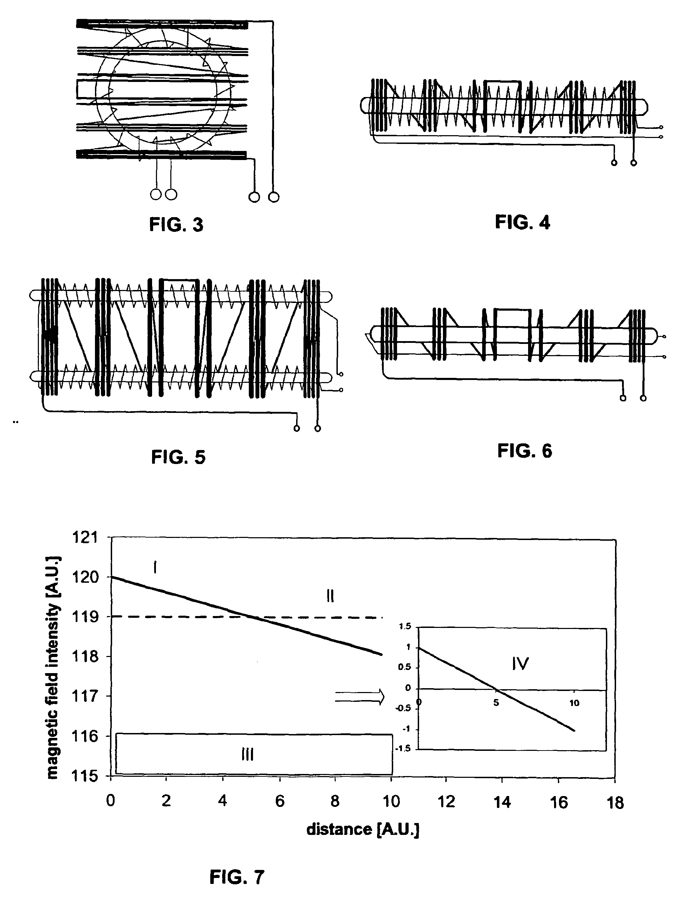

Ferromagnetic cores in the sensor may have also other shapes and various orientation of excitation and measured fields than those shown in fig. 1, which shows parallel-type sensor with oval core "race-track". Embodiment for an Aschenbrenner-Göbau parallel-type sensor with circular shape is shown in fig. 3, for a parallel-type sensor with single core in fig. 4, for a Vacquier parallel-type sensor in fig. 5 and finally the fig. 6 shows the embodiment for a sensor with excitation field perpendicular to the measured field.

Fluxgate sensor circuit according to the fig. 1 operates as follows.

Excitation block 9 creates the alternating current with frequencies 2f and f. Signal with frequency f is amplified and led into the excitation winding 2 or directly into the ferromagnetic core 1, which induces the alternating current flowing through the excitation winding 2 or the ferromagnetic core 1. Given by the fluxgate sensor operating principle, this current periodically overexcites the ferromagnetic core 1 until the ferromagnetic material is saturated. Excitation block 9 simultaneously provides a reference signal 2f for detection electronics blocks. Alternating output signal from the gradient compensating/pick-up coil 4 is led to the first signal processing block 61, which is controlled by the reference signal from the excitation block 9 and this reference signal is phase-shifted by the first phase shifter 7. In this first signal processing block 61 the alternating output signal from the gradient compensating/pick-up coil 4 is demodulated, for example by a phase-sensitive detector, into even harmonics of the basic frequency. The output of this first signal processing block 61 is a signal proportional to the first-order gradient of the magnetic field. This signal is further led to the first inverting integrator 62 and the output of this first inverting integrator 62 is led to the first U/I converter 63. This output current is led backwards to the winding of the gradient compensating/pick-up coil 4, in which it creates the magnetic field gradient with opposite polarity than the measured gradient; measured gradient is therefore compensated by thus created gradient.

Simultaneously, the compensating mode can be used also for the homogeneous component of the field. In such a case, the alternating output signal from the homogeneous compensating/pick-up coil 3 is led to the second signal processing block 51, which is controlled by the reference signal from the excitation block 9 and this reference signal is phase-shifted by the second phase shifter 8. In this second signal processing block 51 the alternating output signal of the homogeneous compensating/pick-up coil 3 is demodulated, for example by a phase-sensitive detector, into even harmonics of the basic frequency. The output of this second signal processing block 51 is a signal proportional to the homogeneous component of the magnetic field. This signal is further led to the second inverting integrator 52 and the output of this second inverting integrator 52 is led to the second U/I converter 53. This output current is led backwards into the winding of the homogeneous compensating/pick-up coil 3, in which it induces homogeneous component of the magnetic field with opposite polarity than the homogeneous component of the measured field; this component is therefore compensated by thus created homogeneous field.

Principle of the new solution is therefore creating the compensating gradient magnetic field by means of the gradient compensating/pick-up coil 4 connected in the feedback circuit, which introduces the compensating mode in the fluxgate sensor. The fluxgate sensor can also simultaneously compensate the homogeneous component of the field by means of the homogeneous compensating/pick-up coil 3 in the second compensating feedback loop. Based on the compensated fluxgate sensor function principle, the homogeneous component means the arithmetic average of the magnetic field flux curve over the length of the homogeneous compensating/pick-up coil 3. Individual curves are shown in fig. 7, where I is the general magnetic field flux curve with gradient nature, II is the arithmetic average over the length of the fluxgate sensor, III is the magnetic field compensated by the homogeneous compensating/pick-up coil 3, and IV is the remaining field with gradient nature, which can now be compensated by the gradient compensating/pick-up coil 4.

As already mentioned above, the gradient coil is exploited as a pick-up coil and a compensating coil at the same time for manufacturing facilitation purposes. Gradient nature of the pick-up winding only amplifies the gradient nature of the measured field and the output voltage therefore remains directly proportional to the magnetic gradient and, likewise, the gradient field created by this coil is directly proportional to the current passing through this coil.

To ensure correct function of both independent feedbacks it is necessary to consider imperfections of both coils, it means of the homogeneous compensating/pick-up coil 3 and the gradient compensating/pick-up coil 4, caused by manufacturing tolerances and during their mutual assembly. This makes the operation in compensating mode of the gradient loop, when one feedback affects the other, impossible without having eliminated the component of induced voltage caused by such imperfections. This is achieved by independently variable phase of the detector in the second, gradient feedback loop, which in real conditions is always different from the phase of the detector in the homogeneous feedback loop. As the phases of induced signal in the gradient compensating/pick-up coil 4 and the homogeneous compensating/pick-up coil 3 are different, it is possible to achieve correct function of the gradient feedback at the expense of lower sensitivity.

### Industrial Applicability

Fluxgate sensor circuit for measuring the gradient of a magnetic field will find application in many spheres of technology, such as medicine, aerospace and safety applications requiring to measure local sources of magnetic field and simultaneously to suppress interfering distant magnetic fields, or possibly to directly measure the magnetic gradient as a quantity.

## Claims

1. Fluxgate sensor circuit for measuring the gradient of a magnetic field consisting of a fluxgate sensor with a ferromagnetic core (1) of an arbitrary shape and for parallel or perpendicular direction of an excitation field, where the ferromagnetic core (1) is either equipped with an excitation winding (2) connected to an excitation block (9), or the ferromagnetic core (1) is connected to the excitation block (9) directly, and of a gradient coil (4) with a constant diameter wound concentrically and coaxially around the ferromagnetic core (1) and the gradient coil (4) is connected with the first signal processing block (61), **characterized by** the fact that an homogeneous compensating/pickup coil (3) is wound coaxially and concentrically with respect to the gradient coil (4), this homogeneous compensating/pickup coil (3) is connected to a second signal processing block (51) and this homogeneous compensating/pick-up coil (3) is simultaneously connected with the output of the second U/I converter (53) connected to the output of the second inverting integrator (52), the input of which is connected with the output signal from the second signal processing block (51), and **characterized by** the fact that the gradient coil is created as a gradient compensating/pick-up coil (4), while its winding has the same diameter throughout the whole length and the number of coil turns per length unit decreases linearly from one end of the fluxgate sensor towards its center, where the winding direction turns, and from this center towards the other end of the fluxgate sensor the number of coil turns per length unit increases analogically, and this gradient compensating/pick-up coil (4) is simultaneously connected with the output of the first U/I converter (63), which is connected to the output of the first inverting integrator (62), the input of which is connected with the output of the signal from the first signal processing block (61).

2. Fluxgate sensor circuit according to claim 1 **characterized by** the fact that in addition a first phase shifter circuit (7) is connected between the excitation block (9) and the first signal processing block (61) and a second phase shifter circuit (8) is connected between the excitation block (9) and the second signal processing block (51).

3. Fluxgate sensor circuit according to claim 1 or 2 **characterized by** the fact, that the gradient coil (4) is discretized into a setup of narrow, homogeneously wound sections (41) connected in series, which are located with identical spacing across the gradient coil (4) length, while always the two sections (41) located mutually coaxially against the center of the gradient coil (4) have opposite winding direction and have the same number of coil turns, which decreases linearly from one end of the gradient coil (4) towards its center and from this center it increases analogically towards the other end.

## Patentansprüche

1. Kreis des ferromagnetischen Fühlers zum Zwecke der Messung des Magnetfeldgradienten, bestehend aus dem ferromagnetischen Kern (1) in jedweder Gestalt, entweder mit der parallel oder senkrecht laufenden Richtung des Erregerfeldes, wo der ferromagnetische Kern (1) entweder mit der an den Block (9) der Erregung angeschlossenen Erregerwicklung (2) versehen ist, oder ist der ferromagnetische Kern (1) an den Block (9) der Erregung direkt, sowie von der Gradientenspule (4) mit dem konstanten Durchmesser, gleichmittig und koaxial um den ferromagnetischen Kern (1) aufgewickelt, angeschlossen, wo die jeweilige Gradientenspule (4) mit dem ersten Block (61) für die Signalverarbeitung verbunden ist, **dadurch gekennzeichnet, dass** koaxial und gleichmittig gegenüber der Gradientenspule (4) eine homogene Kompensations/Abtastspule (3) aufgewickelt ist, die mit dem zweiten Block (51) für die Signalverarbeitung verbunden ist, und diese homogene Kompensations/Abtastspule (3) ist gleichzeitig mit dem Ausgang des zweiten Umformers U/I (53) verbunden, der an den Ausgang des zweiten umwandelnden Integriergerätes (52) angeschlossen ist, dessen Eingang mit dem Signalausgang vom zweiten Block (51) für die Signalverarbeitung verbunden ist, und **dadurch gekennzeichnet, dass** die Gradientenspule als Gradienten-Kompensations/Abtastspule (4) ausgeführt ist, deren Wicklung innerhalb der ganzen Länge den gleichen Durchmesser aufweist und die Gewindeanzahl je Längeeinheit vom einem Rand des ferromagnetischen Fühlers zu seiner Mitte, wo sich der Sinn der Wicklung wendet, linear sinkt, und von dieser Mitte zum anderen Rand des ferromagnetischen Fühlers die Gewindeanzahl je Längeeinheit analog steigt, wobei diese Gradienten-Kompensations/Abtastspule (4) gleichzeitig mit dem Ausgang des ersten Umformers U/I (63) verbunden ist, der an den Ausgang des ersten umwandelnden Integriergerätes (62) angeschlossen ist, dessen Eingang mit dem Signalausgang vom ersten Block (61) für die Signalverarbeitung verbunden ist.

2. Kreis des ferromagnetischen Fühlers nach dem Anspruch 1, **dadurch gekennzeichnet, dass** zwischen den Block (9) der Erregung und den ersten Block (61) für die Signalverarbeitung der erste Phasenschieber (7), sowie zwischen den Block (9) der Erregung und den zweiten Block (51) für die Signalverarbeitung der zweite Phasenschieber (8) geschaltet ist.

3. Kreis des ferromagnetischen Fühlers nach den Ansprüchen 1 oder 2, **dadurch gekennzeichnet, dass** die Gradientenspule (4) ins System von engen, homogen gewickelten, serienweise verbundenen Abschnitten (41) diskretisiert ist, die in gleichen Abständen rund um den ferromagnetischen Kern (1) verteilt sind, wobei jeweils zwei gegeneinander koaxial gegenüber der Mitte der Gradientenspule (4) angebrachte Abschnitte (41) den umgekehrten Sinn der Wicklung, sowie die gleiche Gewindeanzahl aufweisen, die von einem Rand der Gradientenspule (4) bis zu seiner Mitte linear sinkt und von dieser Mitte bis zum anderen Rand analog linear steigt.

## Revendications

1. Le circuit du capteur ferromagnétique pour le mesurage d'un gradient de champ magnétique consistant en noyau ferromagnétique (1) de forme arbitraire avec une direction soit parallèle soit perpendiculaire du champ d'excitation, où le noyau ferromagnétique (1) est équipé par l'enroulement d'excitation (2) connecté à un bloc (9) d'excitation ou bien le noyau ferromagnétique (1) est connecté à un bloc (9) d'excitation directement, et en bobine de gradient (4) avec un diamètre constant embobinée de façon concentrique et coaxiale autour du noyau ferromagnétique (1), où cette bobine de gradient (4) est connectée avec le premier bloc (61) de traitement du signal **dont la caractéristique essentielle est que** de façon coaxiale et concentrique par rapport à la bobine de gradient (4), il est embobiné une bobine de compensation/de reprise homogène (3) qui est connectée avec le deuxième bloc (51) de traitement du signal, et cette bobine de compensation /de reprise homogène (3) est en même temps connectée avec la sortie du deuxième convertisseur U/I (53) connecté à la sortie du deuxième intégrateur inversant (52) dont l'entrée est connectée avec la sortie du signal du deuxième bloc (51) de traitement du signal et **caractérisé par le fait que** la bobine de gradient est faite comme une bobine de gradient de compensation /de reprise (4) dont l'enroulement est de diamètre constant le longue de toute la longueur et le nombre de spires par l'unité de longueur s'abaisse linéairement d'un côté du capteur ferromagnétique vers son centre, où le sens de l'enroulement s'inverse, et depuis ce centre vers l'autre côté du capteur ferromagnétique, le nombre de spires par l'unité de longueur augmente d'une façon analogique, et cette bobine de gradient de compensation/de reprise (4) est en même temps connectée avec la sortie du premier convertisseur U/I (63) connecté à la sortie du premier intégrateur inversant (62) dont l'entrée est connectée avec la sortie du signal du premier bloc (61) de traitement du signal.

2. Le circuit du capteur ferromagnétique selon la revendication 1 **caractérisé par le fait qu'**entre le bloc (9) d'excitation et le premier bloc (61) de traitement du signal, il est connecté le premier déphaseur (7) et entre le bloc (9) d'excitation et le deuxième bloc (51) de traitement du signal, il est connecté le deuxième déphaseur (8).

3. Le circuit du capteur ferromagnétique selon la revendication 1 ou 2 **caractérisé par le fait que** la bobine de gradient (4) est discrétisée en système des sections (41) étroites enroulées d'une façon homogène et connectées en série, qui sont réparties avec un espacement équidistant autour de noyau ferromagnétique (1), et toujours deux sections (41) disposées l'une contre l'autre de façon coaxiale par rapport au centre de la bobine de gradient (4) ont la direction opposée de l'enroulement et ont le même nombre de spires qui s'abaisse linéairement d'un côté de la bobine de gradient (4) vers son centre et depuis ce centre vers l'autre côté, il augmente linéairement d'une façon analogique.
